# EUROPEAN PATENT APPLICATION

(11) **EP 1 313 209 A1**
(43) Date of publication of application: **21.05.2003**
(21) Application number: 01204353.5
(22) Date of filing: 14.11.2001
(51) Int. Cl.: H03B 19/10, H03B 27/00, H03D 7/16, H03D 3/00

(54) **Quadrature frequency multiplier**

(71) Applicant: Semiconductor Ideas to The Market (ItoM) BV, 4839 AH Breda (NL)
(72) Inventor: Kasperkovitz, Wolfdietrich Georg, 5581 HA Waalre (NL)
(74) Representative: Van Straaten, Joop

(57) **Abstract**

Frequency multiplier means comprising a frequency doubler having a quadrature input receiving in-phase and phase quadrature components of a quadrature input signal Iin,Qin and a quadrature output providing a quadrature output signal Iout,Qout of a frequency f2, which is double that of said quadrature input signal. To allow easy and robust implementation, the frequency doubler comprises a multiplier circuit for mutually multiplying the in-phase and phase quadrature components of said quadrature input signal Iin,Qin and providing one of the in-phase and phase quadrature components of said quadrature output signal, said in-phase and phase quadrature components of the quadrature input signal Iin,Qin being supplied to first and second squaring circuits, respectively, outputs thereof being coupled to first and second input terminals of a differential circuit providing the other ofthe in-phase and phase quadrature components of said quadrature output signal.

## Description

The invention relates to a quadrature frequency multiplier comprising a frequency doubler having a quadrature input receiving in-phase and phase quadrature components of a quadrature input signal Iin,Qin and a quadrature output providing a quadrature output signal Iout,Qout of a frequency f2, which is double that of said quadrature input signal fl. Such frequency multiplier is on itself known, e.g. from US patent number 5,389,886.

The known quadrature frequency doubler utilizes a pair of multipliers as well as a pair of dual phase shifters preceding these multipliers to provide the desired 90° phase difference between the in-phase and phase quadrature output signals lout and Qout. The 90° phase difference is controlled by choosing an appropriate ratio between a number of resistors within said dual phase shifters. In practice, however, tolerance spread and other sources of mismatch, deteriorate said resistor ratio, and in this way the matching of the quadrature signals. This strongly limits the applicability of the known quadrature frequency doubler and hampers the multiple use thereof in cascaded arrays.

An object of the invention is to provide an accurate quadrature frequency multiplier for input frequencies varying within a relatively large frequency range, which allows for a straightforward and more robust circuit implementation than the above known quadrature frequency doubler.

It is a further object of the invention to provide a quadrature frequency doubler, which can be cascaded for a multiplication factor of 2ⁿ, while securing an accurate 90° phase difference between the in-phase and phase quadrature output signals lout and Qout of the quadrature frequency multiplier

Frequency multiplier means of the type as described in the opening paragraph according to the invention are therefore characterized by a multiplier circuit for mutually multiplying the in-phase and phase quadrature components of said quadrature input signal Iin,Qin and providing one of the in-phase and phase quadrature components of said quadrature output signal, said in-phase and phase quadrature components of the quadrature input signal Iin,Qin being supplied to first and second squaring circuits, respectively, outputs thereof being coupled to first and second input terminals of a differential circuit providing the other of the in-phase and phase quadrature components of said quadrature output signal..

Quadrature frequency doubling according to the invention is based on a goniometric principle using simple mathematical signal operations, like multiplication and summation, allowing for a more simple and robust circuit implementation than the abovementioned known quadrature frequency doubler. By applying the invention the accuracy in the 90° phase difference between the in-phase and phase quadrature components of the quadrature input signal Iin,Qin is not affected, making the circuit suitable for multiple cascaded application.

A preferred embodiment of the invention is therefore characterised by said frequency doubler being included in an array of n cascade connected mutually corresponding further frequency doublers.

To reduce crosstalk from input to output caused e.g. by leakage of the in-phase and phase quadrature components of the quadrature input signal Iin,Qin to the in-phase and phase quadrature terminals of the quadrature output of the frequency multiplier means due to spurious response or unwanted DC offset, a quadrature resonance amplifier is preferably coupled to the quadrature output of said frequency doubler for a pass band selection of the quadrature output signal thereof.

The invention also relates to a receiver comprising an RF tuning stage including a tuning oscillator and a mixer stage for providing frequency conversion of an RF input signal.

According to an aspect of the invention, such receiver is being characterised by an arrangement of said frequency multiplier means and frequency dividers for multiplying, respectively dividing, the frequency of the tuning oscillator with one of n frequency multiplication, respectively dividing, factors to cover one of n mutually substantially complementary tuning subranges within a receiver tuning range corresponding to the frequency range of the RF input signal. This measure allows to use a low cost type voltage controlled oscillator with limited tuning range.

These and further aspects and advantages of the invention will be discussed more in detail hereinafter with reference to the disclosure of preferred embodiments, and in particular with reference to the appended Figures, wherein:
Figure 1 shows an embodiment of frequency multiplying means comprising a single quadrature frequency doubler according to the invention;
Figure 2 shows a multiple use of the frequency doubler of Figure 1 in a cascaded array.
Figure 3 shows a multiple use of the frequency doubler of Figure 1 in an embodiment of a receiver according to the invention together with a plurality of quadrature frequency dividers to boost the frequency variation range of a voltage controlled oscillator.

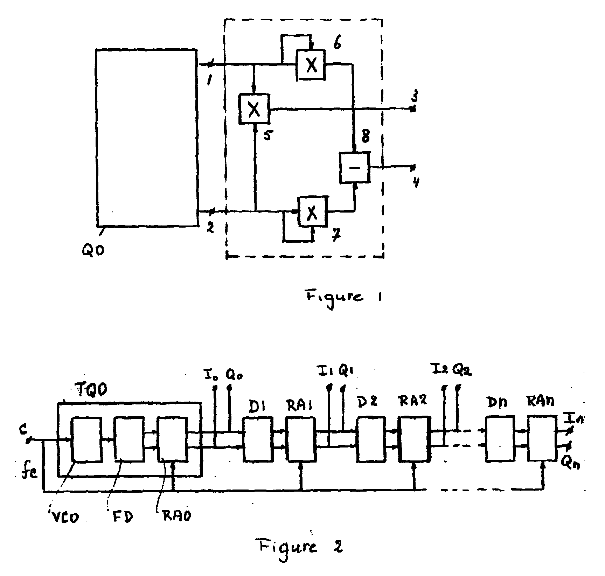

Figure 1 shows an embodiment of a quadrature frequency doubler D according to the invention having in-phase and phase quadrature terminals of a quadrature input 1, 2 receiving in-phase and phase quadrature components of a quadrature input signal Iin,Qin, e.g. sin ω₁t and cos ω₁t in which ω₁ = 2πf₁, from a quadrature oscillator QO and providing at in-phase and phase quadrature terminals of a quadrature output 3, 4, in-phase and phase quadrature components of a quadrature output signal Iout,Qout, respectively. The quadrature frequency doubler D comprises a multiplier circuit 5 being coupled through a pair of inputs to the in-phase and phase quadrature terminals of said quadrature input 1, 2 for mutually multiplying the in-phase and phase quadrature components of said quadrature input signal Iin,Qin into sin ω₁t*cos ω₁t, which in frequency equalizes to sin 2*ω₁t. Therewith the in-phase component lout of said quadrature output signal Iout,Qout is being obtained. The in-phase and phase quadrature terminals of the quadrature input 1, 2 are respectively coupled to first and second squaring circuits 6 and 7, which provide the square value of the in-phase and phase quadrature components of the quadrature input signal Iin,Qin, i.e. sin²ω₁t and cos²ω₁t, at their respective outputs. The outputs of the first and second squaring circuits 6 and 7 are being coupled to first and second input terminals of a differential circuit 8 to form the difference between the square value of the in-phase and phase quadrature components of the quadrature input signal Iin,Qin, i.e. sin²ω₁t - cos²ω₁t. This difference signal sin²ω₁t - cos²ω₁t equalizes in frequency to cos 2*ω₁t, which constitutes the phase quadrature component Qout of said quadrature output signal Iout,Qout of said frequency doubler.

Figure 2 shows an array of cascaded frequency doublers D1-Dn, each corresponding to the frequency doubler of Figure 1. The array is preceded by a tuneable quadrature oscillator TQO comprising a voltage controlled oscillator VCO followed by a phase splitting divide-by-two frequency divider FD. The voltage controlled oscillator VCO generates an oscillator signal at a frequency 2*fin, whereas the phase splitting divide-by-two frequency divider FD provides a conversion of said oscillator signal into in-phase and phase quadrature components of a quadrature input signal Iin,Qin of a frequency fin, hereinafter also being indicated as input frequency. Said quadrature signal is being supplied as a quadrature input signal Iin, Qin to a tuneable quadrature resonance amplifier RA0 for a selective amplification thereof at said input frequency fin. A sinusoidal signal form is therewith obtained, whereas leakage signals because of spurious response and/or DC offset are being reduced. This sinusoidal quadrature input signal Iin, Qin is available for further use at a quadrature output I0, Q0 of the cascade and is simultaneously supplied to the first frequency doubler in the array, i.e. the frequency doubler D1. The frequency doubler D1 derives from said quadrature input signal Iin, Qin a quadrature signal at a frequency of 2*fin, i.e. at double frequency of said quadrature input signal Iin, Qin. This 2*fin quadrature signal is selectively amplified in a tuneable quadrature resonance amplifier RA1 to obtain a quadrature output signal becoming available at a quadrature output I1, Q1 of the cascade and is simultaneously supplied to the second frequency doubler in the array, i.e. the frequency doubler D2. The frequency doubler D2 derives from said quadrature signal a quadrature signal at a frequency of 4*fin, i.e. at fourfold frequency of said quadrature input signal Iin, Qin. This 4*fin quadrature signal is selectively amplified in a tuneable quadrature resonance amplifier RA2 to obtain a quadrature output signal becoming available at output terminals I2, Q2 of the cascade and is simultaneously supplied to the third frequency doubler in the array (not shown), and so forth and so on, until the last frequency doubler in the array, i.e. frequency doubler Dn derives a quadrature signal at a frequency of 2ⁿ*fin, i.e. at 2ⁿ times the input frequency fin, which quadrature signal is selectively amplified in a tuneable quadrature resonance amplifier RAn to obtain a pair of quadrature output signals In, Qn becoming available at output terminals In, Qn of the cascade.

A frequency control signal fc is supplied to the tuning control input of the voltage controlled oscillator VCO as well as to the tuning control input of each tuneable resonance amplifier RA0-RAn in the cascade. The frequency control signal fc provides tracking of the tuning of these tuneable resonance amplifiers RA0-RAn to any variation in the frequency fin of the quadrature tuneable oscillator TQO in order to properly reduce eventual crosstalk from input to output of each frequency doubler caused e.g. by leakage of the in-phase and phase quadrature input signals Iin and Qin to the various quadrature outputs I0,Q0; I1,Q1.....In,Qn of the frequency multiplier means and to restore deviations of the quadrature signals from the sinusoidal signal form.

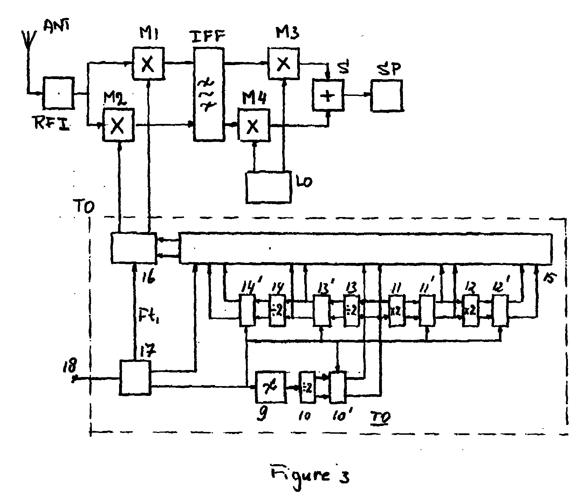

Figure 3 shows an embodiment of a receiver according to the invention comprising an RF input circuit RFI being supplied by antenna means ANT with an RF reception band. The RF input circuit RFI provides broadband selection and amplification and is followed by a quadrature mixer stage comprising a pair of mixers M1 and M2 for a conversion of a wanted RF signal into a quadrature IF (intermediate frequency) signal. For this purpose, the in-phase and phase quadrature components of a quadrature tuning oscillator signal are being supplied from a quadrature tuning oscillator TO to said mixers M1 and M2, respectively. Said quadrature IF (intermediate frequency) signal is supplied to a quadrature IF filter for an IF selection and eventual amplification thereof followed by a demodulation to baseband in a quadrature demodulator comprising a pair of mixers M3 and M4 coupled to a summation device S. The mixers M3 and M4 are being respectively supplied with the in-phase and phase quadrature components of a quadrature local oscillator signal generated by a quadrature local oscillator LO, which can be a fixed oscillator, or a VCO (voltage controlled oscillator) included in a PLL (not shown). The so obtained baseband modulation signal is supplied to signal processing means SP for further processing and reproduction thereof.

The receiver described sofar is on itself known and need no further amplification to properly understand the invention. For further details about function and operation as television or radio receiver reference is made to US patent 4,633,315 and/or DE 34 12 191.

According to the invention, the quadrature tuning oscillator TO of the receiver shown is provided with a VCO (voltage controlled oscillator) 9 followed by a quadrature phase splitting divide-by-two frequency divider 10 and a resonance amplifier 10'. The quadrature tuning oscillator TO is followed on the one hand by frequency multiplier means comprising a cascade arrangement of quadrature frequency doublers 11 and 12, respectively followed by resonance amplifiers 11'and 12', and on the other hand by a cascade arrangement of divide-by-two quadrature frequency divider 13 and 14, respectively followed by resonance amplifiers 13'and 14'. The quadrature outputs of the resonance amplifiers 10'-14' are coupled to quadrature inputs of a switching device 15. Quadrature outputs of the switching device 15 are coupled through a tuneable quadrature bandpassfilter 16 to the mixers M1 and M2. A tuning control signal is supplied from a tuning control input terminal 18 to a tuning signal processor 17 deriving therefrom a frequency control signal ft, a switching control signal s and a filter tuning signal Ft, which are respectively supplied to a tuning control input of the VCO 9 and simultaneously to tuning control inputs of resonance amplifiers 10'-14, the switching device 15 and the tuneable quadrature bandpassfilter 16. Function and operation of said resonance amplifiers 10'-14' and tuneable quadrature bandpassfilter 16 are similar to the resonance amplifiers RA0-Ran of Figure 2.

The quadrature phase splitting divide-by-two frequency divider 10 provides in-phase and phase quadrature components of a quadrature signal of a frequency, which is half of the frequency of the voltage controlled oscillator 9. For the reception of television signals, the voltage controlled oscillator 9 is variable in frequency within a frequency variation range from 250-500MHz, therewith enabling the quadrature output signals of the quadrature phase splitting divide-by-two frequency divider 10 to vary within a frequency variation range or tuning subrange, from 125 to 250MHz. The corresponding tuning subranges of the quadrature output signals of frequency doublers 11 and 12 therewith cover frequencies within frequency variation ranges from 250 to 500MHz and from 500 to 1000MHz, respectively. The corresponding tuning subranges of the quadrature output signals of the divide-by-two quadrature frequency divider 13 and 14 cover frequencies within frequency variation ranges from 67 to 125 and from 34 to 67 MHz, respectively. These subranges are mutually complementary and together cover the full TV RF reception band.

At a certain value of the tuning control signal ft causing the tuning oscillator TO to generate a quadrature oscillator signal of a wanted frequency, e.g. fw, the tuning signal processor 17 provides a tuning control signal value to the VCO 9, such that a quadrature oscillator signal of said wanted frequency fw will appear at one of the quadrature outputs of the frequency dividers 10, 13 and 14 and the frequency doublers 11 and 12 as well as an identification signal identifying the specific subrange covering said wanted frequency fw. Suppose fw is within the tuning subrange of quadrature frequency doubler 11. Then apart from the quadrature signal of the wanted frequency ft, those at 2*fw; 0,5*fw; 0,25*fw and 0,125*fw will be supplied to the switching device 15 as well. By supplying said identification signal as a switching signal to the switching device 15, the quadrature output signals of the relevant frequency divider or doubler, in the present example the frequency doubler 11, is selectively switched through to the tuneable quadrature bandpassfilter 16. The tuneable quadrature bandpassfilter 16 is tuned at the wanted frequency fw with the tuning control signal Ft from the tuning signal processor 17 for a further selection of the wanted pair of quadrature tuning oscillator signals.

The invention is embodied in each new characteristic and each combination of characteristics. Any reference signs do not limit the scope of the claims. The word "comprising" does not exclude the presence of other elements than those listed in a claim. Use of the word "a" or "an" preceding an element does not exclude the presence of a plurality of such elements.

## Claims

1. Frequency multiplier means comprising a frequency doubler having a quadrature input receiving in-phase and phase quadrature components of a quadrature input signal Iin,Qin and a quadrature output providing a quadrature output signal Iout,Qout of a frequency f2, which is double that of said quadrature input signal, **characterised by** a multiplier circuit for mutually multiplying the in-phase and phase quadrature components of said quadrature input signal Iin,Qin and providing one of the in-phase and phase quadrature components of said quadrature output signal, said in-phase and phase quadrature components of the quadrature input signal Iin,Qin being supplied to first and second squaring circuits, respectively, outputs thereof being coupled to first and second input terminals of a differential circuit providing the other of the in-phase and phase quadrature components of said quadrature output signal.

2. Frequency multiplier means according to claim 1, **characterised by** said frequency doubler being included in an array of various of cascade connected mutually corresponding frequency doublers.

3. Frequency multiplier means according to claim 1 or 2, **characterised by** a quadrature resonance amplifier following the quadrature output of said frequency doubler for a pass band selection of the quadrature output signal thereof.

4. Frequency multiplier means according to claim 3, **characterised by** a tuned oscillator preceding said frequency doubler, a tuning control being provided to said tuned oscillator as well as to said quadrature resonance amplifier.

5. Receiver comprising an RF tuning stage including a tuning oscillator and a mixer stage for providing frequency conversion of an RF input signal being **characterised by** an arrangement of frequency multiplier means in accordance with one of claims 1 to 4 and frequency dividers for multiplying, respectively dividing, the frequency of the tuning oscillator with one of n frequency multiplication, respectively dividing, factors to cover one of n mutually substantially complementary tuning subranges within a receiver tuning range corresponding to the frequency range of the RF input signal.
